# EUROPEAN PATENT APPLICATION

(11) **EP 4 647 840 A2**
(43) Date of publication of application: **12.11.2025**
(21) Application number: 25174427.2
(22) Date of filing: 06.05.2025
(51) Int. Cl.: G03F 7/075, G03F 7/09, G03F 7/11

(54) **COMPOUND FOR FORMING METAL-CONTAINING FILM, COMPOSITON FOR FORMING METAL-CONTAINING FILM, AND PATTERNING PROCESS**

(30) Priority: 08.05.2024 JP 2024076133
(71) Applicant: SHIN-ETSU CHEMICAL CO., LTD., Tokyo 1000005 (JP)
(72) Inventor: Kobayashi, Naoki, Niigata (JP); Nagamachi, Nobuhiro, Niigata (JP); Ishiwata, Kenta, Niigata (JP); Kori, Daisuke, Niigata (JP)
(74) Representative: Schicker, Silvia

(57) **Abstract**

An object of the present invention is to provide: a compound for forming a metal-containing film providing a resist middle layer film by which a good pattern shape can be obtained, and that has a high adhesion to a resist upper layer film and suppresses the collapse of a fine pattern in a fine patterning process during a semiconductor device manufacturing process; a composition for forming a metal-containing film using the compound; and a patterning process using the composition.
This provides:
a compound (A) for forming a metal-containing film, wherein
the compound (A) for forming a metal-containing film is a compound comprising at least one kind of metal atom selected from the group consisting of Ti, Zr, and Hf and a ligand coordinated to the metal atom, and
at least one of the ligands is derived from the organic sulfonic acid compound represented by the following formula (s):

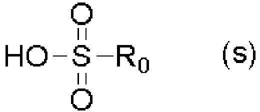

## Description

### TECHNICAL FIELD

The present invention relates to: a compound for forming a metal-containing film that can be used for fine patterning by a multilayer resist method in a semiconductor device manufacturing process; a composition for forming a metal-containing film using the compound; and a patterning process using these materials.

### BACKGROUND ART

Along with high integration and high processing speed of LSI, miniaturization of pattern size is rapidly advancing. Along with the miniaturization, lithography technology has achieved a fine patterning by shortening a wavelength of a light source and selecting an appropriate resist composition accordingly. The composition mainly used is a positive photoresist composition for a monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a photoresist film having a formed pattern as an etching mask. In practice, however, there is no dry etching method capable of providing an absolute etching selectivity between the photoresist film and the substrate to be processed. The photoresist film is thus also damaged and collapses during processing of the substrate, and there is an issue that the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at an exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have a shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, demand for finding a composition used in this processing and the process has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1.

For the silicon-containing resist middle layer film used in the three-layer resist method as described above, silicon-containing inorganic films produced by CVD, for example, SiO₂ films (e.g., Patent Document 2) and SiON films (e.g., Patent Document 3), are used. For films obtained by spin-coating, SOG (spin-on-glass) films (e.g., Patent Document 4, Non-Patent Document 1), crosslinked silsesquioxane films (e.g., Patent Document 5), etc. are used, and polysilane films (e.g., Patent Document 6) may also be used. Among these, SiO₂ films and SiON films have high performance as a dry etching mask when dry etching the organic underlayer film; however, they require special equipment for forming the film. On the other hand, SOG films, crosslinked silsesquioxane films, and polysilane films can be formed simply by spin-coating and heating, and are considered to offer high process efficiency.

Silicon-containing films that have been used conventionally in such multilayer resist methods have several problems. For example, it is well known that when attempting to form a resist pattern by photolithography, the exposure light is reflected by the substrate and interferes with the incident light, causing the problem of so-called standing waves. In order to obtain a fine pattern without edge roughness in the resist film under cutting-edge ArF liquid immersion and high NA exposure conditions, a middle layer film with an anti-reflective function is essential. Furthermore, in the cutting-edge semiconductor processes as described above, photoresist films are becoming thinner, which requires the middle layer films also to be thinner. In the next-generation exposure processes, an anti-reflective effect needs to be provided with a film thickness of 30 nm or less. In addition, the dry etching speed for oxygen gas plasma, which is generally used during processing a resist underlayer film, is preferably as small as possible in order to increase the etching selectivity ratio between the middle layer film and the underlayer film, and the trend toward thinner films is leading to demand for improvement of dry etching resistance for the middle layer film.

As a resist middle layer film that satisfies the requirements for an anti-reflective effect and dry etching properties, metal hard mask films containing Ti or Zr have been attracting attention as an alternative to conventional silicon-containing films. TiO₂ and ZrO₂ are known to be high-refractive-index materials, and by including these in a film, it is possible to improve the anti-reflective effect under high NA exposure conditions. Furthermore, by including a metal-oxygen bond, excellent dry etching resistance to oxygen gas can be expected.

In addition, since metal hard mask films have excellent dry etching resistance not only to oxygen gas but also to fluorine gas, they are also promising for use in a two-layer resist method in which a metal hard mask film is formed as a resist underlayer film on a substrate to be processed and then a resist upper layer is formed onto it.

On the other hand, when such a metal hard mask film is used directly below a resist upper layer film, improving adhesion to the resist pattern will be an issue. A cured metal hard mask film has a much higher surface energy (or lower water contact angle) than the subsequently applied photoresist. Such a surface energy mismatch causes poor adhesion between a metal hard mask film and the subsequently applied photoresist, resulting in pattern collapse.

In order to suppress the photoresist pattern collapse on a metal hard mask film, surface modification of the metal hard mask film is required. For example, in Patent Document 7, a metal hard mask containing a surface-modified organic polymer is reported. It has been reported that the difference in free energy between an organic polymer and a metal compound can be used to unevenly distribute the organic polymer on the surface layer, thereby improving adhesiveness to the resist pattern. To suppress pattern collapse, organic polymers containing a surface-treated part selected from a hydroxyl, a protected hydroxyl, a protected carboxyl, and mixtures thereof have been used. However, in the current situation where finer pattern formation is required, with these materials, the suppression effect against pattern collapse is not sufficient. Furthermore, since containing an organic polymer may reduce the dry etching resistance to oxygen gas, there is demand for the development of a compound for forming a metal-containing film that has excellent adhesiveness to resist upper layer films.

Recently, the interaction at the interface between a resist upper layer film and an underlayer film directly below the resist upper layer film in a fine pattern is considered to affect the sensitivity of the resist, the shape of the pattern (rectangularity and space residues), etc. From these perspectives as well, there is demand for performance improvement of the underlayer film directly below the resist upper layer film (Non-Patent Document 2).

### CITATION LIST

### PATENT LITERATURE

Patent Document 1: JP 2004-205685 A
Patent Document 2: JP H07183194 A
Patent Document 3: JP H07181688 A
Patent Document 4: JP H05291208 A
Patent Document 5: JP 2005-520354 A
Patent Document 6: JP H1160735 A
Patent Document 7: JP 6463600 B2

### NON PATENT LITERATURE

Non-Patent Document 1: J. Appl. Polym. Sci., Vol. 88, 636-640 (2003)
Non-Patent Document 2: Proc. SPIE Vol. 7273, 72731J (2009)

### SUMMARY OF INVENTION

### TECHNICAL PROBLEM

The present invention has been made in view of the above-described circumstances. An object of the present invention is to provide: a compound for forming a metal-containing film providing a resist middle layer film by which a good pattern shape can be obtained and also having a high adhesion to a resist upper layer film and suppressing the collapse of a fine pattern in a fine patterning process in a semiconductor device manufacturing process; a composition for forming a metal-containing film using the compound; and a patterning process using the composition.

### SOLUTION TO PROBLEM

To achieve the object, the present invention provides:
a compound (A) for forming a metal-containing film, wherein
the compound (A) for forming a metal-containing film is a compound comprising at least one kind of metal atom selected from the group consisting of Ti, Zr, and Hf and a ligand coordinated to the metal atom, and
at least one of the ligands is derived from the organic sulfonic acid compound represented by the following formula (s): 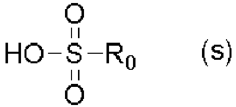
wherein R₀ represents a monovalent organic group having 1 to 30 carbon atoms, and containing at least one of the following: an unsaturated hydrocarbon group excluding an aromatic ring; and an alkoxy group.

If used in a composition for forming a metal-containing film, such a compound for forming a metal-containing film can improve adhesion to a resist upper layer film, and the shape of the resist pattern after exposure and development will be rectangular. This enables substrate processing with fine patterns.

The R₀ is preferably a monovalent organic group having 1 to 30 carbon atoms and containing at least one of the following: a vinyl group; an allyl group; an allyloxy group; an ethynyl group; a propargyl group; a propargyloxy group; and an alkoxy group.

If used in a composition for forming a metal-containing film, such a compound for forming a metal-containing film can improve adhesion to a resist upper layer film, and the shape of the resist pattern after exposure and development will be rectangular. This enables substrate processing with fine patterns.

The R₀ is preferably an alkyl group having 2 to 30 carbon atoms or an aryl group having 7 to 30 carbon atoms and containing at least one functional group selected from the following: a vinyl group; an allyl group; an allyloxy group; an ethynyl group; a propargyl group; a propargyloxy group; and an alkoxy group.

If used in a composition for forming a metal-containing film, such a compound for forming a metal-containing film can improve adhesion to a resist upper layer film, and the shape of the resist pattern after exposure and development will be rectangular. This enables substrate processing with fine patterns.

The R₀ is preferably an aryl group having 7 to 30 carbon atoms and containing at least one functional group selected from the following: a vinyl group; an allyl group; an allyloxy group; an ethynyl group; a propargyl group; a propargyloxy group; and an alkoxy group.

Such a compound for forming a metal-containing film improves the heat resistance, and if used in a composition for forming a metal-containing film, it can further improve adhesiveness to a resist upper layer film, and the shape of the resist pattern after exposure and development will be rectangular. This enables substrate processing with fine patterns.

The compound (A) for forming a metal-containing film preferably further contains a ligand derived from a silicon compound represented by the following general formula (w): 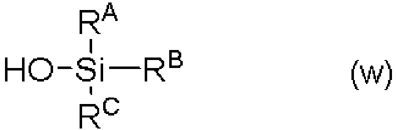 wherein R^{A}, R^{B}, and R^{C} each represent any organic group selected from the following: an organic group having 2 to 30 carbon atoms and a crosslinking group of a structure represented by one of the following general formulae (w-1) to (w-3); a substituted or unsubstituted alkyl group having 1 to 20 carbon atoms; and an aryl group having 6 to 20 carbon atoms: 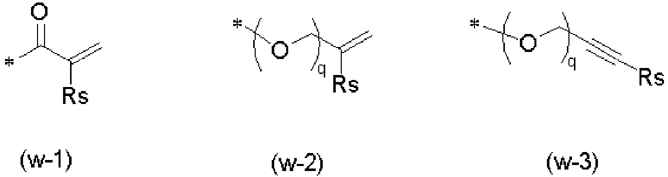 wherein Rₛ represents a hydrogen atom or a monovalent organic group having 1 to 10 carbon atoms, "q" represents 0 or 1, and "*" represents an attachment point.

By having the compound further contain a ligand derived from a silicon compound represented by the general formula (w), stability of the metal compound in solution can be improved.

The compound (A) for forming a metal-containing film is preferably a reaction product of the following: a metal compound represented by the following formula (a) or a metal compound containing either a hydrolysate, a condensate, or a hydrolysis condensate of a metal compound represented by the following formula (a); and a compound containing a structure represented by the formula (s):

LₐMX_{b} **(a)**

wherein M is any one of Ti, Zr, and Hf; L is a monodentate ligand or a multidentate ligand having 1 to 30 carbon atoms; X is a hydrolyzable group selected from the following: a halogen atom; an alkoxy group; a carboxylate group; an acyloxy group; and -NR¹R², wherein R¹ and R² are each independently a hydrogen atom or a monovalent organic group having 1 to 20 carbon atoms; and "a" and "b" each represent an integer from 0 to 4 such that a + b = 2 to 4.

By using such a metal compound, a metal-containing film having even better dry etching resistance to fluorine gas and oxygen gas can be formed.

The formula (a) preferably has a structure represented by the following formula (a-1):

M(OR^{1A})₄ (a-1)

wherein M is any one of Ti, Zr, and Hf, and R^{1A} is a monovalent organic group having 1 to 20 carbon atoms.

A metal compound having such a structure is preferable from the viewpoints of productivity and availability of raw materials.

In addition, the present invention also provides a composition for forming a metal-containing film, wherein the composition for forming a metal-containing film serves as a metal-containing film used in semiconductor manufacturing, and contains the compound (A) for forming a metal-containing film and an organic solvent (B).

Such a composition for forming a metal-containing film contains a metal-containing compound having excellent dry etching resistance in relation to conventional resist underlayer film materials and also having excellent adhesion and wet etchability in relation to resist middle layer films.

The composition preferably further contains at least one kind from among the following: a crosslinking agent (C); an acid generator (D); and a surfactant (E).

If the composition for forming a metal-containing film contains the above additives, it is possible to obtain a composition for forming a metal-containing film having even better coating properties, dry etching resistance, and filling and/or planarizing properties.

The organic solvent (B) preferably includes, as a high-boiling-point solvent (B1), at least one kind of organic solvent having a boiling point of 180°C or higher.

By providing thermal flowability to the compound for forming a metal-containing film by adding a high-boiling-point solvent (B1), coat defects in the composition for forming a metal-containing film due to dryness can be suppressed.

Furthermore, the present invention also provides a patterning process for forming a pattern in a substrate to be processed, comprising the steps of:
(I-1) applying the composition for forming a metal-containing film directly or indirectly onto a substrate to be processed, followed by heating to form a metal-containing film;
(I-2) forming a resist upper layer film directly or indirectly on the metal-containing film by using a photoresist material;
(I-3) subjecting the resist upper layer film to pattern exposure and then development with a developer to form a pattern in the resist upper layer film;
(I-4) transferring the pattern directly or indirectly to the metal-containing film by dry etching using the resist upper layer film having the formed pattern as a mask; and
(I-5) processing the substrate to be processed directly or indirectly while using the metal-containing film having the formed pattern as a mask to form the pattern in the substrate to be processed.

Such a patterning process has high adhesion to the resist upper layer film and can prevent collapse of the fine pattern.

Furthermore, the patterning process of the present invention may include at least one organic resist underlayer film between the substrate to be processed and the metal-containing film.

Such a patterning process can transfer a pattern onto a substrate to be processed with high accuracy.

Furthermore, in the patterning process of the present invention, the resist upper layer film is preferably formed directly on the metal-containing film.

The metal-containing film formed using the compound for forming a metal-containing film of the present invention has excellent adhesiveness to the resist upper layer film, and therefore a resist upper layer film pattern with high rectangularity can be obtained.

Moreover, the patterning process of the present invention preferably includes a step of forming a pattern by processing a film directly below the metal-containing film using the metal-containing film as a mask, followed by a step of removing the metal-containing film with a chemical solution.

Such a patterning process can easily remove the metal-containing film while suppressing damage to the substrate, and therefore can form a pattern with excellent rectangular cross-sectional shape.

The chemical solution is preferably a solution containing hydrogen peroxide and an acid, or a solution containing a base, hydrogen peroxide and water.

Such a chemical solution can easily remove the metal-containing film formed using the compound for forming a metal-containing film of the present invention.

### ADVANTAGEOUS EFFECTS OF INVENTION

As described above, the inventive compound for forming a metal-containing film has at least one ligand derived from the organic sulfonic acid compound represented by the formula (s). Therefore, when a metal-containing film is formed using this compound, adhesiveness to the resist upper layer film can be improved, and the shape of the resist pattern after exposure and development will be rectangular. Therefore, a composition for forming a metal-containing film using the compound and a patterning process used in the composition can be suitably used in a patterning process such as a multilayer resist process.

### BRIEF DESCRIPTION OF DRAWINGS

FIG. 1 is an explanatory view of an example (three-layer resist process) of the patterning process of the present invention.
FIG. 2 is an explanatory view of an example (three-layer resist process) of the patterning process using wet etching of the present invention.

### DESCRIPTION OF EMBODIMENTS

As described above, the present invention provides: a compound for forming a metal-containing film that has high adhesion to a resist upper layer film and has an effect of suppressing collapse of a fine pattern; a composition for forming a metal-containing film using the compound; and a patterning process using the composition.

A resist underlayer film formed using a conventional compound for forming a metal-containing film has a much higher surface energy (or a smaller water contact angle) than a subsequently applied photoresist, and such a mismatch in surface energy causes poor adhesion between the metal-containing film and the subsequently applied photoresist, resulting in pattern collapse. Furthermore, if an organic polymer is mixed in as a surface modifier, the dry etching resistance during processing of the organic underlayer film becomes insufficient, which may induce poor pattern transfer.

As a result of earnest research into the above-mentioned problems, the present inventors have found that the above-mentioned problems can be solved by a patterning process using a compound for forming a metal-containing film containing a ligand of a specific structure, a composition for forming a metal-containing film using the compound, and the composition. Thus, they completed the present invention.

That is, the present invention is:
a compound (A) for forming a metal-containing film, wherein
the compound (A) for forming a metal-containing film is a compound comprising at least one kind of metal atom selected from the group consisting of Ti, Zr, and Hf and a ligand coordinated to the metal atom, and
at least one of the ligands is derived from the organic sulfonic acid compound represented by the following formula (s): 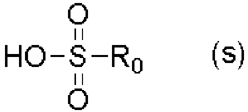 wherein R₀ represents a monovalent organic group having 1 to 30 carbon atoms and containing at least one of the following: an unsaturated hydrocarbon group excluding an aromatic ring; and an alkoxy group.

In addition, the present invention is a composition for forming a metal-containing film, wherein the composition for forming a metal-containing film serves as a metal-containing film used in semiconductor manufacturing, and contains the compound (A) for forming a metal-containing film and an organic solvent (B).

Hereinafter, the present invention will be described in detail, but the present invention is not limited thereto.

### <Compound for Forming Metal-Containing Film>

A compound (A) for forming a metal-containing film, wherein
the compound (A) for forming a metal-containing film is a compound comprising at least one kind of metal atom selected from the group consisting of Ti, Zr, and Hf and a ligand coordinated to the metal atom, and
at least one of the ligands is derived from the organic sulfonic acid compound represented by the formula (s).

If used in a composition for forming a metal-containing film, such a metal compound can form a metal-containing film that has excellent dry etching resistance in relation to conventional resist underlayer film materials and has excellent adhesiveness in relation to resist upper layer films.

In the formula (s), R₀ is preferably a monovalent organic group having 1 to 30 carbon atoms and containing at least one of the following: a vinyl group; an allyl group; an allyloxy group; an ethynyl group; a propargyl group; a propargyloxy group; and an alkoxy group; and is more preferably an alkyl group having 2 to 30 carbon atoms or an aryl group having 7 to 30 carbon atoms and containing at least one functional group selected from the following: a vinyl group; an allyl group; an allyloxy group; an ethynyl group; a propargyl group; a propargyloxy group; and an alkoxy group.

By containing such a functional group, a crosslinking reaction between the ligands proceeds, and a metal-containing film having excellent adhesiveness to the resist upper layer film can be formed.

The alkyl group and the aryl group may have a functional group other than the functional group selected from the following: a vinyl group; an allyl group; an allyloxy group; an ethynyl group; a propargyl group; a propargyloxy group; and an alkoxy group. For example, the hydrogen atoms on the alkyl group and the aryl group may be substituted with halogen atoms, halogenated alkyl groups, etc.

Examples of compounds derived from the above ligands include the following structures:

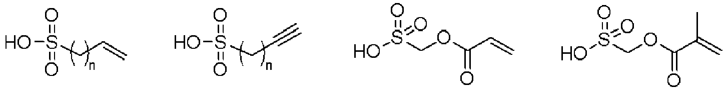

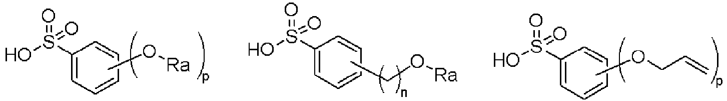

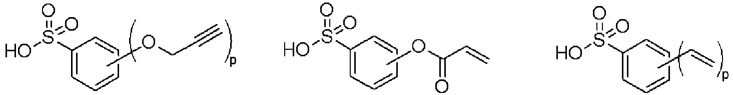

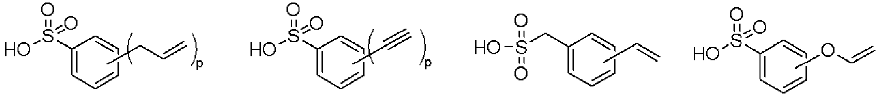

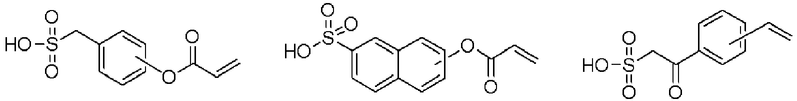

In the above structures, the hydrogen atoms may be substituted with a substituted or unsubstituted alkyl group having 1 to 10 carbon atoms, a substituted or unsubstituted aryl group having 6 to 20 carbon atoms, an organic group having 2 to 10 carbon atoms and including a substituted or unsubstituted unsaturated hydrocarbon (excluding an aromatic ring), a halogen atom, or an alkyl halide group. Rₐ represents a substituted or unsubstituted alkyl group having 1 to 10 carbon atoms or a substituted or unsubstituted aryl group having 1 to 10 carbon atoms, "p" represents 1 to 5, and "n" represents 1 to 10.

In the formula (s), R₀ is more preferably an aryl group having 7 to 30 carbon atoms and containing at least one functional group selected from the following: a vinyl group; an allyl group; an allyloxy group; an ethynyl group; a propargyl group; a propargyloxy group; and an alkoxy group.

Such a compound for forming a metal-containing film improves heat resistance, and is thought to cause crosslinking reactions between ligands to be promoted more. If this is used in a composition for forming a metal-containing film, the adhesion to the resist upper layer film can be further improved, and the shape of the resist pattern after exposure and development will be rectangular. This enables substrate processing with fine patterns.

The sulfonic acid organic compound more preferably has a structure represented by the following formula (s-1):

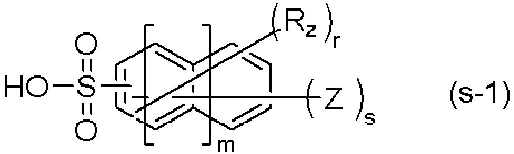

In the structure, Z represents an organic group having 1 to 10 carbon atoms and containing at least one of the following: a vinyl group; an allyl group; an allyloxy group; an ethynyl group; a propargyl group; a propargyloxy group; and an alkoxy group; R_{z} represents a monovalent organic group having 1 to 10 carbon atoms; "m" represents 0 or 1; "s" represents 1 or 2; and "r" represents 0 to 2.

In the formula (s-1), R_{z} is preferably any one of the following: a substituted or unsubstituted alkyl group having 1 to 10 carbon atoms; a substituted or unsubstituted aryl group having 6 to 10 carbon atoms; a substituted or unsubstituted alkoxy group having 1 to 10 carbon atoms; an organic group having 2 to 10 carbon atoms and containing a substituted or unsubstituted unsaturated hydrocarbon (excluding an aromatic ring); a halogenated alkyl group having 1 to 10 carbon atoms; and a halogen atom.

From the viewpoint of dry etching resistance, in the formula (s-1), preferably, "m" is 0, "s" is 1, and "r" is 0 or 1.

The compound (A) for forming a metal-containing film is preferably a reaction product of the following: a metal compound represented by the following formula (a) or a metal compound containing either a hydrolysate, a condensate, or a hydrolysis condensate of a metal compound represented by the following formula (a); and a compound containing a structure represented by the formula (s):

LₐMX_{b} (a)

wherein M is any one of Ti, Zr, and Hf; L is a monodentate ligand or a multidentate ligand having 1 to 30 carbon atoms; X is a hydrolyzable group selected from the following: a halogen atom; an alkoxy group; a carboxylate group; an acyloxy group; and -NR¹R², wherein R¹ and R² are each independently a hydrogen atom or a monovalent organic group having 1 to 20 carbon atoms; and "a" and "b" each represent an integer from 0 to 4 such that a + b = 2 to 4.

If used in a composition for forming a metal-containing film, such a compound for forming a metal-containing film can form a metal-containing film having excellent dry etching resistance to fluorine gas and oxygen gas.

### [Metal-containing compound (a)]

### (Hydrolyzable group)

Examples of hydrolyzable groups X represented by the formula (a) include a halogen atom, an alkoxy group, a carboxylate group, an acyloxy group and -NR¹R². R¹ and R² are preferably each independently a hydrogen atom or a monovalent organic group having 1 to 20 carbon atoms.

Examples of the halogen atom include a fluorine atom, a chlorine atom, a bromine atom, and an iodine atom.

Examples of the alkoxy group include a methoxy group, an ethoxy group, an n-propoxy group, an i-propoxy group, an n-butoxy group, and a t-butoxy group.

Examples of the carboxylate group include an acetate group, a propionate group, a butyrate group, an n-hexanecarboxylate group, and an n-octanecarboxylate group.

Examples of the acyloxy group include an acetoxy group, an ethyloxy group, a propionyloxy group, a butyryloxy group, a t-butyryloxy group, a t-amylyloxy group, an n-hexanecarbonyloxy group, and an n-octanecarbonyloxy group.

Examples of the -NR¹R² include an unsubstituted amino group, a methylamino group, a dimethylamino group, a diethylamino group, and a dipropylamino group.

The hydrolyzable group X is preferably an alkoxy group, and more preferably an i-propoxy group, an n-butoxy group, or a t-butoxy group.

### (Monodentate ligand)

Examples of the monodentate ligand include a hydroxo ligand, a carboxy ligand, an amide ligand, an amine ligand, an ammonia ligand, and an olefin ligand.

Examples of the amide ligand include an unsubstituted amide ligand (NH₂), a methylamide ligand (NHMe), a dimethylamide ligand (NMe₂), a dimethylamide ligand (NEt22), and a dipropylamide ligand (NPr₂).

Examples of the amine ligand include pyridine, a trimethylamine ligand, and a piperidine ligand.

Examples of the olefin ligand include chain olefins such as ethylene and propylene, and cyclic olefins such as cyclopentene, cyclohexene and norbornene.

### (Multidentate ligand)

Examples of the multidentate ligand include a ligand derived from a hydroxy acid ester, a ligand derived from a β-diketone, a ligand derived from a β-ketoester, a ligand derived from an α,α-dicarboxylate ester, a hydrocarbon having a π bond, and a diphosphine.

Examples of the hydroxy acid ester include glycolic acid ester, lactic acid ester, 2-hydroxycyclohexane-1-carboxylic acid ester, and salicylic acid ester.

Examples of the β-diketone include acetoacetate ester, α-alkyl-substituted acetoacetate ester, β-ketopentanoate ester, benzoylacetate ester, and 1,3-acetonedicarboxylate ester.

Examples of the α,α-dicarboxylic acid ester include malonic acid diester, α-alkyl-substituted malonic acid diester, α-cycloalkyl-substituted malonic acid diester, and α-aryl-substituted malonic acid diester.

Examples of the hydrocarbon having a π bond include chain dienes such as butadiene and isoprene, cyclic dienes such as cyclopentadiene, methylcyclopentadiene, pentamethylcyclopentadiene, cyclohexadiene, and norbornadiene, and aromatic hydrocarbons such as benzene, toluene, xylene, hexamethylbenzene, naphthalene, and indene.

Examples of the diphosphines include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, and 1,1'-bis(diphenylphosphino)ferrocene.

In the above general formula (a), "a" and "b" each represent an integer from 0 to 4 such that a + b = 2 to 4. "a" is preferably 0 to 4, and more preferably 2 or 4. "b" is preferably 0 to 4, and more preferably 0, 2 or 4. By setting "a" and "b" within the above ranges, the stability of the compound (A) for forming a metal-containing film can be increased.

Examples of preferred compounds for forming a metal-containing film represented by formula (a) include the following:
examples of compounds containing titanium include titanium(IV) diisopropoxybis(2,4-pentanedionate), titanium(IV) tetra n-butoxide, titanium(IV) tetra n-propoxide, titanium(IV) tetraisopropoxide, titanium(IV) tri n-butoxymonostearate, titanium(IV) butoxide oligomer, titanium(IV) aminopropyltrimethoxate, titanium(IV) triethoxymono(2,4-pentanedionate), titanium(IV) tri-n-propoxymono(2,4-pentanedionate), titanium triisopropoxymono(2,4-pentanedionate), and titanium(IV) di-n-butoxybis(2,4-pentanedionate);
examples of compounds containing zirconium include zirconium(IV) dibutoxybis(ethylacetoacetate), zirconium(IV) di-n-butoxybis(2,4-pentanedionate), zirconium(IV) tetra-n-butoxate, zirconium(IV) tetra-n-propoxate, zirconium(IV) tetraisopropoxate, zirconium(IV) aminopropyltriethoxate, zirconium(IV) 2-(3,4-epoxycyclohexyl)ethyltrimethoxate, γ-glycidoxypropionate, zirconium(IV) trimethoxate, zirconium(IV) 3-isocyanopropyltrimethoxate, zirconium(IV) triethoxymono(2,4-pentanedionate), zirconium(IV) tri-n-propoxymono(2,4-pentanedionate), zirconium(IV) triisopropoxymono(2,4-pentanedionate), zirconium(IV) tri(3-methacryloxypropyl)methoxate, and zirconium(IV) tri(3-acryloxypropyl)methoxate; and examples of compounds containing hafnium include hafnium(IV) diisopropoxybis(2,4-pentanedionate), hafnium(IV) tetrabutoxate, hafnium(IV) tetraisopropoxate, hafnium(IV) tetraethoxate, and hafnium(IV) dichlorobis(cyclopentadienylate).

Among the above, metal alkoxides, metal carboxylates, and metal acetates are more preferable, and from the viewpoint of availability of raw materials, a structure represented by the following formula (a-1) is further preferable:

M (OR^{1A}) ₄ (a - 1)

wherein M is any one of Ti, Zr, and Hf, and R^{1A} is a monovalent organic group having 1 to 20 carbon atoms.

In the formula (a-1), R^{1A} represents a monovalent organic group having 1 to 20 carbon atoms, and is preferably a methyl group, an ethyl group, an n-propyl group, an i-propyl group, an n-butyl group, or a t-butyl group, and more preferably an isopropyl group, an n-butyl group, or a t-butyl group.

During the synthesis reaction of the compound (A) for forming a metal-containing film, in addition to a metal compound (a), a compound that can become a monodentate or polydentate ligand in the compound for forming a metal-containing film (hereinafter referred to as compound (b) for forming a ligand) may be added.

Examples of the compound (b) for forming a ligand include the following: organic compounds derived from hydroxo ligands, carboxy ligands, amide ligands, amine ligands, ammonia ligands, olefin ligands, etc., which are listed as L in the above general formula (a); organic compounds derived from ligands derived from hydroxy acid esters, ligands derived from β-diketones, ligands derived from β-ketoesters, and ligands derived from α,α-dicarboxylates, etc.; and in addition, compounds having compounds that have multiple hydroxy groups.

In the compound (A) for forming a metal-containing film, the contained amount of the ligand derived from the compound containing the structure represented by the formula (s) is preferably 10 mol% to 90 mol%, more preferably 20 mol% to 80 mol%, and further preferably 25 mol% to 75 mol% of the contained amount of the total ligands coordinated to the metal atom. The contained amount of a ligand other than the compound containing the structure represented by the formula (s), for example, the compound (b) for forming a ligand and ligands derived from an alkoxy group having 1 to 10 carbon atoms, is preferably 0 mol % to 90 mol % and more preferably 20 mol % to 80 mol %, of the contained amount of the total ligands coordinated to the metal atom.

Furthermore, during the synthesis reaction of the compound (A) for forming a metal-containing film, other than a compound (b) for forming a ligand, a silicon-containing compound (c) may be added.

By substituting the hydrolyzable group of the metal compound (a) with a silicon-containing compound, the stability of the compound (A) for forming a metal-containing film in the composition for forming a metal-containing film can be improved.

Examples of the silicon-containing compound (c) include a structure represented by the following formula (w): 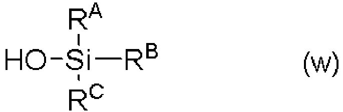 wherein R^{A}, R^{B}, and R^{C} each represent any organic group selected from the following: an organic group having 2 to 30 carbon atoms and a crosslinking group of any structure represented by one of the following general formulae (w-1) to (w-3); a substituted or unsubstituted alkyl group having 1 to 20 carbon atoms; and an aryl group having 6 to 20 carbon atoms: 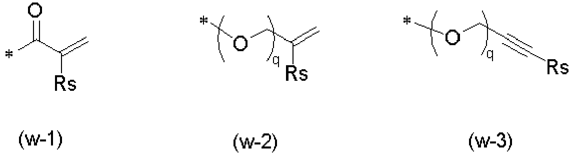 wherein Rₛ represents a hydrogen atom or a monovalent organic group having 1 to 10 carbon atoms, "q" represents 0 or 1, and "*" represents an attachment point.

As the silicon-containing compound (c), a compound represented by any of the following formulae is more preferable, and from the viewpoint of productivity, trimethylsilanol is more preferable:

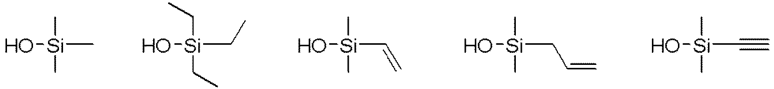

When the compound (A) for forming a metal-containing film contains a ligand derived from a compound having a structure represented by the formula (s) and ligand derived from the silicon-containing compound (c), the contained amount of the ligand derived from the compound having a structure represented by the formula (s) in the compound (A) for forming a metal-containing film is preferably 10 mol% to 100 mol%, more preferably 20 mol% to 80 mol%, and further preferably 25 mol% to 75 mol% of the contained amount of the total ligands coordinated to the metal atom. The contained amount of the ligand derived from the silicon-containing compound (c) is preferably 10 mol% to 90 mol%, more preferably 20 mol% to 80 mol%, and further preferably 25 mol% to 75 mol% of the contained amount of total ligands coordinated to the metal atom. The contained amount of a ligand other than the compound (b) for forming a ligand and the silicon-containing compound (c), for example, a ligand derived from an alkoxy group having 1 to 10 carbon atoms, is preferably 0 mol% to 90 mol% and more preferably 0 mol% to 75 mol% of the contained amount of the total ligands coordinated to the metal atom.

The method for synthesizing the compound (A) for forming a metal-containing film is not particularly limited. For example, a metal alkoxide, a metal carboxylate, or a metal acetylacetonate (acac) can be used as the metal compound (a), and it can be obtained by reacting an alkoxy, a carboxy, or an acac metal with a ligand derived from a compound having a structure represented by the formula (s). It may also be obtained by hydrolysis condensation of the metal compound (a) followed by reaction with the ligand derived from the compound containing the structure represented by the formula (s), or it may also be obtained by reaction of the metal compound (a) with the ligand derived from the compound containing the structure represented by the formula (s) followed by hydrolysis condensation. If it is difficult to control the hydrolysis condensation, the metal compound may be reacted with the ligand derived from compound having a structure represented by the formula (s) in a non-water-containing environment. It is preferable to appropriately adjust these depending on the properties required for the compound (A) for forming a metal-containing film and the metal-containing film. If the silicon-containing compound (c) and the compound having a structure represented by the formula (s) are to be provided as ligands, it is preferable to react the metal compound (a) and silicon-containing compound (c) together, then react the result with the ligand derived from the compound having a structure represented by the above formula (s).

Examples of methods for carrying out a hydrolysis and condensation reaction using the metal compound (a) include methods such as carrying out a hydrolysis and condensation reaction of the metal compound (a) in a solvent containing water. In this case, other compounds having a hydrolyzable group may be added as necessary. Furthermore, as a catalyst for the hydrolysis and condensation reaction, an acid such as acetic acid may be added. The lower limit for the amount of water used in this hydrolysis and condensation reaction is preferably times 0.2 by mole, more preferably times 1 by mole, and further preferably times 3 by mole in relation to the hydrolyzable groups possessed by the metal compound (a), etc. The upper limit for the amount of the water is preferably times 20 by mol, more preferably times 15 by mol, and further preferably times 10 by mol.

The solvent used in the synthesis reaction of the compound (A) for forming a metal-containing film is not particularly limited, and for example, similar solvents as those given as examples of a solvent (B) described below can be used. Typical solvents and solvent mixtures include esters, ethers, or alcohol functional groups: for example, a mixture of propylene glycol monomethyl ether acetate (PGMEA) and propylene glycol monomethyl ether (PGME) at 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, and cyclopentyl methyl ether.

### <Solvent (B)>

The solvent (B) that can be used in the inventive composition for forming a metal-containing film is not particularly limited as long as it is a solvent can dissolve the compound (A) for forming a metal-containing film and, if contained, a crosslinking agent (C), an acid generator (D), a surfactant (E), and any other additives.

Specifically, an organic solvent disclosed in paragraphs [0091] and [0092] in JP2007-199653A may be added. More specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The contained amount of the organic solvent is preferably 200 to 10,000 parts by mass and more preferably 250 to 5,000 parts by mass per 100 parts by mass of the compound (A) for forming a metal-containing film.

### <High-Boiling-Point Solvent (B1)>

In the composition for forming a metal-containing film of the present invention, the solvent (B) may include a high-boiling-point solvent (B1).

As the high-boiling-point solvent (B1), one or more kinds of organic solvents having a boiling point of 180°C or higher may be used.

For example, the solvent (B) may be a mixture of one or more kinds of organic solvent having a boiling point lower than 180°C and one or more kinds of organic solvent having a boiling point of 180°C or higher (high-boiling-point solvent (B1)).

The high-boiling-point solvent (B1) is not particularly limited to hydrocarbons, alcohols, ketones, esters, ethers, or chlorine-based solvents as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate. One of these solvents may be used by itself or a mixture of them may be used.

The high-boiling-point solvent (B1) may be selected from the solvents above, for example, to suit the temperature at which the composition for forming a metal-containing film of the present invention is to be heat-treated at, etc. The boiling point of the high-boiling-point solvent (B1) is preferably 180°C to 300°C and more preferably 200°C to 300°C. With such a boiling point, defect generation due to drying can be suppressed at the time of film formation, since there is no risk of an excessive evaporation rate during baking (heating). Moreover, a solvent having such a boiling point will not remain in the film without evaporating even after baking. Therefore, there is no risk of the solvent adversely affecting the film's physical properties, such as etching resistance.

Furthermore, if the high-boiling-point solvent (B1) is used, the contained amount is preferably 1 to 30 parts by mass per 100 parts by mass of the organic solvent having a boiling point lower than 180°C. With such a contained amount is as described, sufficient thermal flowability can be imparted during baking, so the solvent will not remain in the film and cause degradation in the film's physical properties, such as etching resistance. Therefore, such an amount is preferable.

### <Other Components>

If the composition for forming a metal-containing film is one that serves as a metal-containing film used in semiconductor manufacturing and comprises the compound (A) for forming a metal-containing film and the organic solvent (B) described above, it may contain at least one kind from among the following: a crosslinking agent (C); an acid generator (D); and a surfactant (E).

The following will describe the components that may be contained in the inventive composition for forming a metal-containing film other than the compound (A) for forming a metal-containing film and the organic solvent (B) .

### [Crosslinking Agent (C)]

To increase the curability and further inhibit intermixing with the resist upper layer film, a crosslinking agent (C) may be added to the inventive composition for forming a metal-containing film. The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (C) can be used, or two or more kinds can be used in combination, and if the crosslinking agent is added, the added amount is preferably 5 to 50 parts and more preferably 10 to 40 parts per 100 parts of the compound (A) for forming a metal-containing film. If the added amount is 5 parts or more, sufficient curing properties will be exhibited and intermixing with the resist upper layer film can be suppressed. On the other hand, if the added amount is 50 parts or less, there is no risk of deterioration in dry etching resistance due to a decrease in the ratio of the compound (A) for metal-containing film in the composition.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N', N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (10):

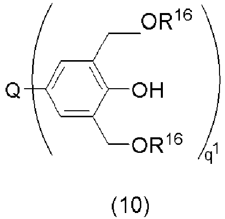

In the formula, Q represents a single bond or a hydrocarbon group having a valency of "q¹" and 1 to 20 carbon atoms. R¹⁶ represents a hydrogen atom or an alkyl group having 1 to 20 carbon atoms. "q¹" represents an integer between 1 and 5.

Q represents a single bond or a hydrocarbon group having a valency of "q¹" and 1 to 20 carbon atoms. "q¹" represents an integer from 1 to 5, and more preferably 2 or 3. Specific examples of Q include groups obtained by removing "q¹" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (10) include the following compounds. Among these, a hexamethoxymethylated derivative of triphenolmethane, triphenolethane, 1,1,1-tris(4-hydroxyphenyl)ethane, and tris(4-hydroxyphenyl)-1-ethyl-4-isopropylbenzene are preferable from the viewpoint of improving the curability and film thickness uniformity of the adhesive film.

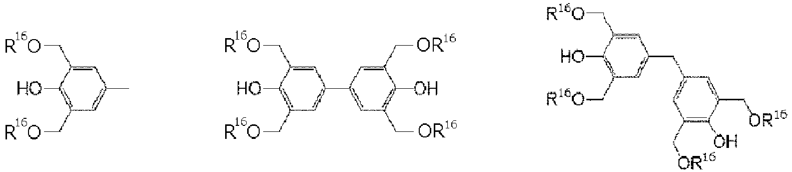

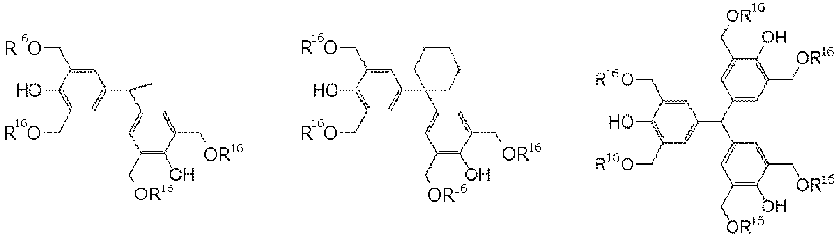

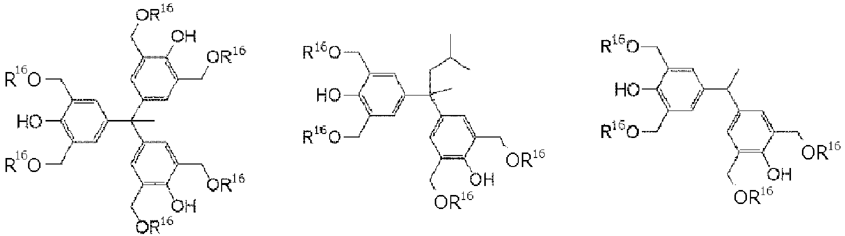

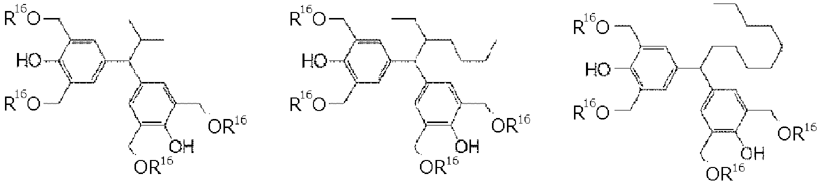

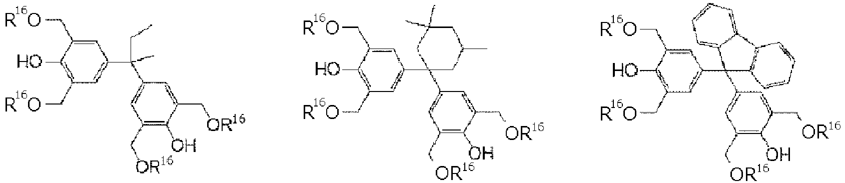

In the formulae, R¹⁶ is the same as in the formula (10) .

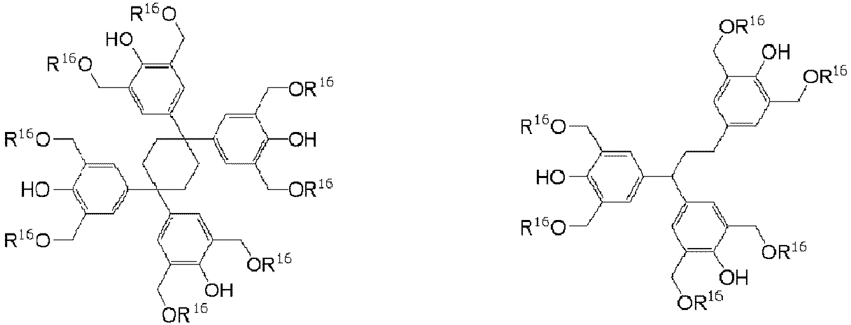

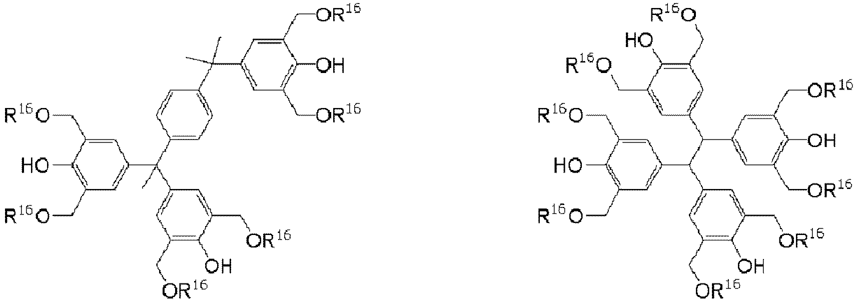

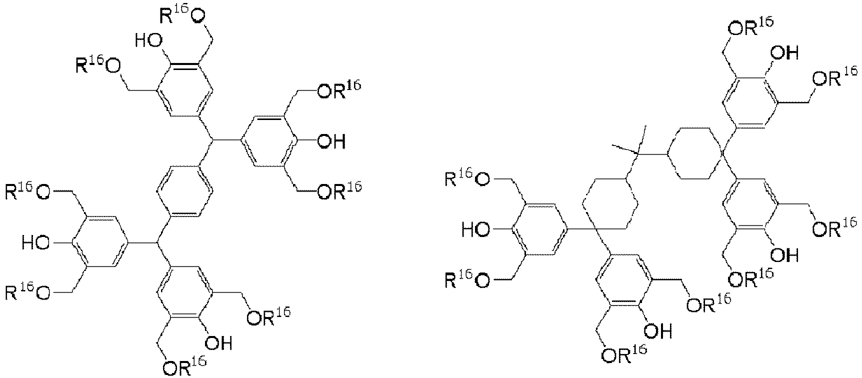

In the formulae, R¹⁶ is the same as in the formula (10).

### <Acid Generator (D)>

An acid generator may be added to the inventive composition for forming a metal-containing film in order further to promote the curing reaction of the compound (A) for forming a metal-containing film. Acid generators can be classified into ones that generate an acid by thermal decomposition and ones that generate an acid by optical irradiation; however, any acid generator may be added. Specific examples include the materials disclosed in paragraphs [0061] to [0085] of JP2007-199653A, but the choice is not limited thereto.

One kind of the acid generator can be used, or two or more kinds can be used in combination. If an acid generator is added, the added amount is preferably 0.05 to 50 parts by mass and more preferably 0.1 to 10 parts by mass per 100 parts by mass of the compound (A) for forming a metal-containing film.

### <Surfactant (E)>

A surfactant (E) may be added to the inventive composition for forming a metal-containing film in order to improve the coating properties in spin-coating. Examples of the surfactant include those disclosed in paragraphs [0142] to [0147] of JP2009-269953A. If the surfactant is added, the added amount is preferably 0.01 to 10 parts by mass and more preferably 0.05 to 5 parts by mass per 100 parts by mass of the compound (A) for forming a metal-containing film.

### <Composition for Forming Metal-Containing Film>

The present invention provides a method for forming, by using the above-described composition for forming a metal-containing film, a metal-containing film of a multilayer resist film used in lithography or a filling film that serves as a planarizing film for semiconductor manufacturing.

In the method for forming a metal-containing film by using the inventive composition for forming a metal-containing film, the substrate to be processed is coated with the above-described composition for forming a metal-containing film by a spin-coating method or the like. Using the spin-coating method or the like ensures desirable filling properties. After spin-coating, baking (heating) is performed in order to evaporate the solvent and promote a crosslinking reaction to prevent mixing of the resist underlayer film with the resist upper layer film or the resist middle layer film. The baking is preferably performed at a temperature of 100°C or higher and 600°C or lower for 10 to 600 seconds, and more preferably at a temperature of 150°C or higher and 500°C or lower for 10 to 300 seconds. Taking into consideration influences on device damage, wafer deformation, and the like, the upper limit for the heating temperature in the wafer process of lithography is preferably not more than 600°C and more preferably not more than 500°C.

Furthermore, in the method for forming a metal-containing film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas such as N₂, Ar, or He therein to reduce the amount of oxygen. Control of oxygen concentration is necessary to prevent oxidation; the oxygen concentration is preferably 1,000 ppm or less and more preferably 100 ppm or less (volumetric basis). By thus preventing oxidation of the metal-containing film during the baking, the absorption will not increase and the etching resistance will not decrease, which is preferable.

### <Patterning Process Using Composition for Forming Metal-Containing Film>

Furthermore, the present invention provides, as a patterning process according to a multilayer resist process using the above-described composition for forming a metal-containing film, a patterning process for forming a pattern in a substrate to be processed, comprising the steps of:
(I-1) applying the composition for forming a metal-containing film directly or indirectly onto a substrate to be processed, followed by heating to form a metal-containing film;
(I-2) forming a resist upper layer film directly or indirectly on the metal-containing film by using a photoresist material;
(I-3) subjecting the resist upper layer film to pattern exposure and then development with a developer to form a pattern in the resist upper layer film;
(I-4) transferring the pattern directly or indirectly to the metal-containing film by dry etching using the resist upper layer film having the formed pattern as a mask; and
(I-5) processing the substrate to be processed directly or indirectly while using the metal-containing film having the formed pattern as a mask to form the pattern in the substrate to be processed.

### (Three-Layer Resist Process)

For example, as a patterning process by a three-layer resist process using the composition for forming a metal-containing film, a patterning process is provided comprising forming an organic resist underlayer film on a substrate to be processed using an organic resist underlayer film material, forming a metal-containing film on the organic resist underlayer film using the composition for forming a metal-containing film of the present invention, forming a resist upper layer film on the metal-containing film using a photoresist material, exposing the resist upper layer film to a pattern, developing the resist upper layer film with a developer to form a pattern in the resist upper layer film, using the resist upper layer film having the formed pattern as a mask to transfer the pattern to the metal-containing film by dry etching, using the metal-containing film having the transferred pattern as a mask to transfer the pattern to the organic resist underlayer film by dry etching, and processing the substrate to be processed using the organic resist underlayer film having the formed pattern as a mask to form a pattern on the substrate to be processed.

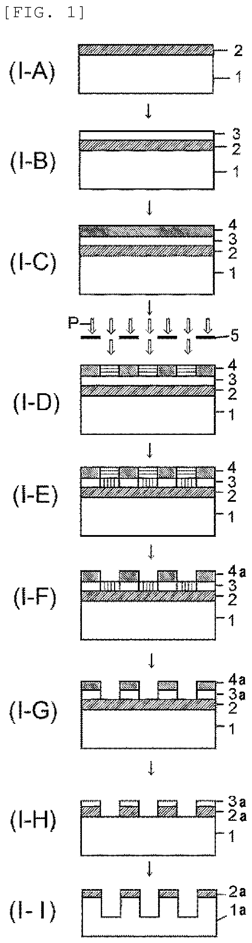

FIG. 1 shows the patterning process using the three-layer resist process. First, an organic resist underlayer film 2 is formed on a substrate to be processed 1 using an organic resist underlayer film material (I-A). Next, a metal-containing film 3 is formed on the organic resist underlayer film 2 using a composition for forming a metal-containing film of the present invention (I-B). Next, a resist upper layer film 4 is formed on the metal-containing film 3 using a photoresist material (I-C). Exposure P is performed with a mask 5 (I-D), the resist upper layer film 4 and the metal-containing film 3 are exposed (I-E), then a resist upper layer film pattern 4a is formed on the resist upper layer film 4 (I-F). The pattern is transferred to the metal-containing film 3 by dry etching while using the resist upper layer film using the obtained resist upper layer film pattern 4a as a mask (I-G). After removing the resist upper layer film pattern 4a, the obtained metal-containing film pattern 3a is used as a mask to transfer the pattern to the organic resist lower layer film 2 by dry etching, thereby transferring the organic resist lower layer film pattern 2a (I-H). After removing the metal-containing film pattern 3a, the substrate to be processed 1 is processed using the obtained organic resist underlayer film pattern 2a as a mask, to form a pattern 1a on the substrate (I-I).

The resist upper layer film in the three-layer resist process described above exhibits etching resistance with respect to chlorine-based gas. Therefore, the dry etching of the metal-containing film that is performed using the resist upper layer film as a mask in the three-layer resist process is preferably performed using an etching gas mainly consisting of a halogen-based gas.

The metal-containing film of the resist middle layer film in the three-layer resist process exhibits etching resistance with respect to an oxygen-based gas. Therefore, the dry etching of the metal-containing film that is performed using the metal-containing film as a mask in the three-layer resist process is preferably performed using an etching gas mainly consisting of an oxygen-based gas.

The organic resist underlayer film in the three-layer resist process described above exhibits etching resistance with respect to fluorine-based gas. Therefore, the dry etching of the substrate to be processed that is performed using the organic resist underlayer film as a mask in the three-layer resist process is preferably performed using an etching gas mainly consisting of a fluorine-based gas.

As an organic resist underlayer film material that can be used for the organic underlayer film, it is possible to use: materials already known to be materials for three-layer resist methods or materials for an underlayer film containing a silicon resist composition for two-layer resist methods; materials known to be resist underlayer film materials for two-layer resist methods and three-layer resist methods, such materials including various resins, including a 4, 4'-(9-fluorenylidene)bisphenol novolak resin (molecular weight: 11,000) disclosed in JP2005-128509A, and also other novolak resins; etc. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic resist underlayer film can be formed on the substrate to be processed by using a composition solution and by a spin-coating method or the like in the same manner as the photoresist composition. After forming the organic underlayer film by a spin-coating method or the like, it is desirable to bake the substrate in order to evaporate the organic solvent. The baking temperature is preferably 80 to 400°C, and the baking time is preferably 10 to 300 seconds.

Instead of the organic resist underlayer film materials, it is also possible to adopt an organic hard mask formed by a CVD method or an ALD method.

In the patterning process, the resist upper layer film may be either a positive type or a negative type, and the same photoresist compositions as those usually used can be used. When the photoresist composition is used to form a resist upper layer film, it may be formed by a spin -coating method or a deposition treatment according to a CVD method or an ALD method.

In cases where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, and particularly preferably 20 to 400 nm.

Examples of light for exposure include high-energy beams at wavelengths of 300 nm or less, specifically excimer lasers at 248 nm, 193 nm, and 157 nm, soft X-rays at 3 to 20 nm, an electron beams, X-rays, and the like.

As the method for forming a pattern in the resist upper layer film, it is preferable to use a patterning process using photolithography with a wavelength of 5 nm or more and 300 nm or less, direct drawing using an electron beam, nanoimprinting, or a combination thereof. However, EUV light is the most preferable in the present invention.

Furthermore, the development method in the patterning process is preferably alkali development or development using an organic solvent.

Next, etching is performed while using the obtained resist pattern as a mask. The etching of a metal-containing film in the three-layer resist process is performed while using the resist upper layer film pattern as a mask by using a fluorocarbon-based gas. This forms a metal-containing film pattern.

Next, an etching process for an organic resist underlayer film is performed while using the obtained metal-containing film pattern as a mask. The etching of the organic underlayer film is preferably performed using an etching gas mainly consisting of an oxygen-based gas.

The metal-containing film obtained by using the inventive composition for forming a metal-containing film is characterized by its excellent etching resistance during etching of these organic resist underlayers.

The subsequent etching of a substrate to be processed may also be performed according to a usual manner. For example, in the case of a substrate to be processed made of SiO₂, SiN, or silica-based low-dielectric-constant insulating film, the etching is performed mainly based on a fluorocarbon-based gas.

Examples of the body to be processed (substrate to be processed) used include, but are not particularly limited to, substrates made of Si, α-Si, p-Si, SiO₂, SiN, SiON, W, TiN, Al, etc., and ones in which the layers to be processed are formed on the substrate. Examples of the layers to be processed include various low-k films such as ones made of Si, SiO₂, SiON, SiN, p-Si, α-Si, W, W-Si, Al, Cu, Al-Si, and the like and stopper films for them, which can each be typically formed into a thickness of 50 to 10,000 nm, and particularly 100 to 5,000 nm. When the layer to be processed is formed, the substrate and the layer to be processed are made of different materials.

### (Two-Layer Resist Process)

Furthermore, the present invention can provide a patterning process by a two-layer resist process using the composition for forming a metal-containing film, consisting of the steps of: forming a metal-containing film on a substrate to be processed using the composition for forming a metal-containing film, forming a resist upper layer film on the metal-containing film using a photoresist material, exposing the resist upper layer film to light and developing it with a developer to form a pattern in the resist upper layer film, transferring the pattern to the metal-containing film by dry etching using the resist upper layer film having the formed pattern as a mask, and processing the substrate to be processed by dry etching using the metal-containing film having the transferred pattern as a mask to form a pattern on the substrate to be processed.

The metal-containing film obtained by using the inventive composition for forming a metal-containing film is characterized by its excellent etching resistance during etching of the substrate to be processed. Therefore, the dry etching that is performed on the substrate to be processed while using the metal-containing film as a mask in the two-layer resist process is preferably performed using an etching gas mainly consisting of a fluorine-based gas.

### (Peeling Process of Metal-Containing Film)

Furthermore, in the present invention, the step to remove the metal-containing film remaining on the film-to-be-processed pattern using a chemical solution is preferably included after the step of processing a film directly below the metal-containing film (hereinafter referred to as a processed film. For example, in the case of the three-layer resist process, it refers to the organic resist underlayer film, and in the case of the two-layer resist process, it refers to the substrate to be processed.) to form a pattern on the processed film. When this step is carried out after the film-to-be-processed etching step, the metal-containing film remaining on the upper side of the substrate is removed. Furthermore, this step can also be performed on a patterned or unpatterned metal-containing film prior to the substrate etching step.

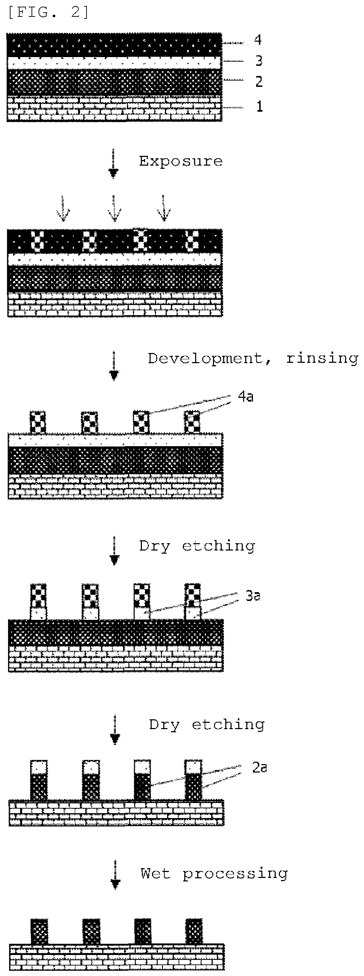

The wet etching method is shown in Figure 2. In a processed body having an organic resist underlayer film 2, a metal-containing film 3, and a resist upper layer film 4 formed on a substrate to be processed 1, first, proximity exposure is performed on the resist upper layer film 4. Thereafter, development and rinsing are carried out to form a resist upper layer film pattern 4a. Thereafter, a metal-containing film pattern 3a is obtained by transferring a pattern to the metal-containing film 3 by dry etching while using the obtained resist upper layer film pattern 4a as a mask. Thereafter, the resist upper layer film pattern 4a is removed, and the resulting metal-containing film pattern 3a is used as a mask to perform dry etching. The pattern is transferred to an organic resist underlayer film 2, and thereby, an organic resist underlayer film pattern 2a is obtained. Thereafter, the metal-containing film pattern 3a is removed by wet etching.

The metal-containing film of the present invention can be removed by wet processing using a chemical solution, so that a pattern can be formed without damaging the substrate to be processed.

Examples of methods for removing the metal-containing film include a method of dry etching the metal-containing film and a method of contacting the metal-containing film with a liquid such as a basic liquid or an acidic liquid.

The acid-containing removal liquid is not particularly limited as long as it is an acidic solution containing an acid, but from the viewpoint of further improving the removability of the metal-containing film, a liquid containing hydrogen peroxide and an acid is preferable, and more specifically, an aqueous solution containing hydrochloric acid and hydrogen peroxide (SC-2 chemical solution), an aqueous solution containing sulfuric acid and hydrogen peroxide (SPM chemical solution), or an aqueous solution containing hydrofluoric acid and hydrogen peroxide (FPM chemical solution) is particularly preferable.

The base-containing removal solution is not particularly limited as long as it is a basic solution containing a base. Examples of bases include sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, dimethylethanolamine, triethanolamine, tetramethylammonium hydroxide (hereinafter also referred to as "TMAH"), tetraethylammonium hydroxide, pyrrole, piperidine, choline, 1,8-diazabicyclo[5.4.0]-7-undecene, and 1,5-diazabicyclo[4.3.0]-5-nonene. Among these, ammonia is preferable from the viewpoint of avoiding damage to the substrate.

As the base-containing removal liquid, from the viewpoint of further improving the removability of the metal-containing film, a liquid containing a base and water, or a liquid containing a base, hydrogen peroxide, and water is preferable, and more specifically, a mixed aqueous solution of ammonia and hydrogen peroxide (a mixed aqueous solution of 25% ammonia aqueous solution / 30% hydrogen peroxide aqueous solution / water = 1/2/40, or a mixed aqueous solution of 25% ammonia aqueous solution / 30% hydrogen peroxide aqueous solution / water = 1/1/5 (SC1)) is particularly preferable.

The wet etching method is not particularly limited as long as it is a method that allows the metal-containing film and the stripping solution to come into contact with each other for a certain period of time under heated conditions. Examples of the method include a method of immersing a substrate having a metal-containing film in a heated alkaline hydrogen peroxide solution, a method of spraying an alkaline hydrogen peroxide solution in a heated environment, and a method of coating on a heated alkaline hydrogen peroxide solution. After each of these methods, the substrate may be rinsed with water and dried.

When the metal-containing film removal step is carried out using a peeling chemical solution, the lower limit of the temperature is preferably 23°C, preferably 40°C, and more preferably 50°C. The upper limit of the temperature is preferably 100°C, and more preferably 90°C.

In the immersion method, the lower limit of the immersion time is preferably 1 second, more preferably 10 seconds, further preferably 20 seconds, and particularly preferably 30 seconds. From the viewpoint of suppressing the influence on the substrate, the upper limit of the immersion time is preferably 60 minutes, more preferably 30 minutes, further preferably 20 minutes, and particularly preferably 10 minutes.

### EXAMPLE

The present invention is more specifically described below with reference to Synthesis Examples, Comparative Synthesis Examples, Examples, and Comparative Examples. However, the present invention is not limited to these Examples.

### [Synthesis Examples]

In the following Synthesis Examples and Comparative Examples, the following organic group raw material groups G ((G1) to (G7)) and silicon-containing organic group raw material group H1 (trimethylsilanol) were used.

The raw material groups G ((G1) to (G7)) are shown below.

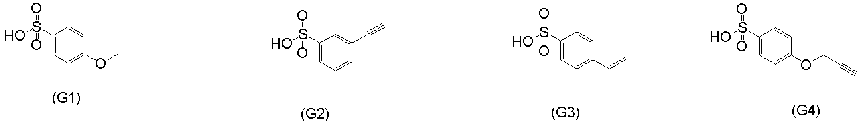

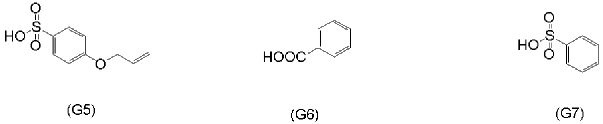

As a metal source M, the following metal compounds were used.
(M1): Titanium tetraisopropoxide (377996 manufactured by Sigma-Aldrich Corp.)
(M2): Zr(OBu)₄: zirconium(IV)tetrabutoxide (80 mass% solution in 1-butanol) (Z0016 manufactured by Tokyo Chemical Industry Co., Ltd.)
(M3): Hf(OBu): hafnium(IV)n-butoxide (667943 manufactured by Sigma-Aldrich Corp)

### [Synthesis Example 1] Synthesis of Compound for Forming Metal-Containing Film (A-1)

Under a nitrogen atmosphere, 7.10 g of titanium tetraisopropoxide (M1) was dissolved in 15.00 g of a PGMEA/PGME (ratio by weight: 70/30) solution. The reaction temperature was raised to 60°C with stirring, and a mixture of 4.70 g of compound G1 suspended in 5.50 g of a PGMEA/PGME (ratio by weight 70/30) solution was added to the reaction system, and stirring was continued for 1 hour with the reaction temperature keeping at 60°C. After cooling to room temperature, the obtained reaction solution was filtered with a 0.45-µm PTFE filter. Thus, a solution of a compound (A-1) for forming a metal-containing film in PGMEA/PGME was obtained.

### [Synthesis of Compounds (A-2) to (A-5) and Comparative Examples (R-1) to (R-2)]

The compounds (A-2) to (A-5) and Comparative Examples (R-1) to (R-2) shown in Table 1 were obtained under the same reaction conditions as in Synthesis Example 1, except that the metal source M, the compound group G, and the compound group H were used at the charging amounts shown in Table 1. (A-1) is also shown together in Table 1.

**[Table 1]**

| Synthesis Example | Metal compound | | Organic ligand | | Compound for forming metal-containing film |
|---|---|---|---|---|---|
| | Symbol | Parts by mass | Composition | Parts by mass | |
| 1 | M1 | 7.10 | G1 | 4.70 | A-1 |
| 2 | M2 | 12.00 | G2 | 4.55 | A-2 |
| 3 | M3 | 11.89 | G3 | 4.60 | A-3 |
| 4 | M2 | 12.00 | G4 | 5.30 | A-4 |
| 5 | M2 | 12.00 | G5 | 5.36 | A-5 |
| 6 | M2 | 12.00 | G6 | 3.05 | Comparative Example R-1 |
| 7 | M2 | 12.00 | G7 | 3.95 | Comparative Example R-2 |

### [Synthesis Example 8] Synthesis of Compound for Forming Metal-Containing Film (A-6)

Under a nitrogen atmosphere, 12.00 g of zirconium (IV) tetrabutoxide (M2) was dissolved in 15.00 g of a PGMEA/PGME (ratio by weight: 70/30) solution. The reaction temperature was raised to 50°C while stirring, and 6.76 g of the compound H1 was added dropwise to the solution. After the addition, stirring was continued for 2 hours at a reaction temperature of 60°C. Subsequently, a mixture obtained by suspending 3.05 g of the compound G4 in 5.50 g of a PGMEA/PGME (ratio by weight: 70/30) solution was added to the reaction system, and stirring was continued for 1 hour with the reaction temperature keeping at 60°C. After cooling to room temperature, the obtained reaction solution was filtered with a 0.45-µm PTFE filter. Thus, a solution of a compound (A-6) for forming a metal-containing film in PGMEA/PGME was obtained.

### [Synthesis Example 9] Synthesis of Compound for Forming Metal-Containing Film (A-7)

Under a nitrogen atmosphere, 59.95 g of zirconium (IV) tetrabutoxide (M2) was dissolved in 50.00 g of 1-butanol, and a solution of 1.69 g of deionized water in 70.00 g of 2-butanol was added dropwise to the solution at room temperature over 2 hours with stirring. 26.53 g of the compound G4 was added to the obtained solution and agitated at room temperature for 30 minutes. After the solution was concentrated under reduced pressure at 30°C, it was heated to 60°C and heating was continued under reduced pressure until no distillate was generated. Then 100.50 g of PGMEA/ PGME (ratio by weight 70/ 30) solution was added thereto and heated under reduced pressure at 40°C until no IPA was distilled, to obtain a PGMEA solution of a metal-containing compound (A-7).

### Preparation of Compositions for Forming Metal-Containing Film (UDL-1 to 10, Comparative UDL-1 to 2)

For the preparation of a composition for forming a metal-containing film, the polymer compounds (A-1) to (A-7), (D-1) as an acid generator, (XL-1) to (XL-2) as crosslinking agents, and F1 (ethylene glycol dibenzyl ether: boiling point 364°C) as a high boiling point solvent (B1) were used. The compositions for forming a metal-containing film (UDL-1 to -10, comparative UDL-1 and -2) were each prepared by dissolving in an organic solvent in the proportions shown in Table 2, and filtering the solution through a 0.1-µm filter made of a fluororesin.

(CH₃CH₂)₃N⁺H

C₄F₉SO₃⁻

### (D-1)

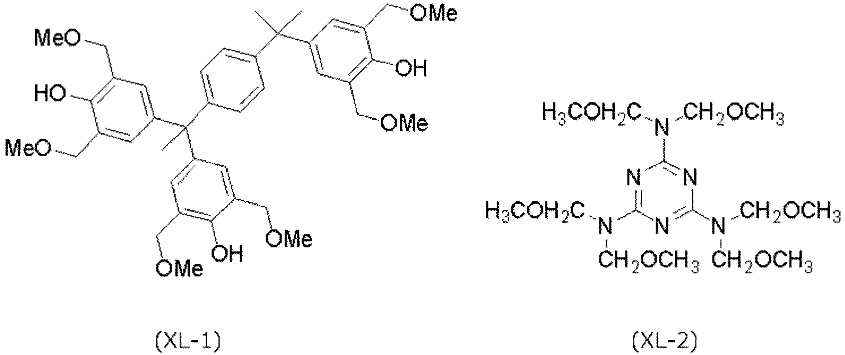

**[Table 2]**

| Composition for forming metal-containing film | Compound for forming metal-containing film | Additive | Solvent |
|---|---|---|---|
| | (parts by mass) | (parts by mass) | (parts by mass) |
| UDL-1 | A-1 (3) | - | PGMEA/PGME (77/20) |
| UDL-2 | A-2 (3) | - | PGMEA/PGME (77/20) |
| UDL-3 | A-3 (3) | - | PGMEA/PGME (77/20) |
| UDL-4 | A-4 (3) | - | PGMEA/PGME (77/20) |
| UDL-5 | A-5 (3) | - | PGMEA/PGME (77/20) |
| UDL-6 | A-6 (3) | - | PGMEA/PGME (77/20) |
| UDL-7 | A-7 (3) | - | PGMEA/PGME (77/20) |
| UDL-8 | A-4 (3) | F-1 (5) | PGMEA/PGME (77/20) |
| UDL-9 | A-4 (3) | XL-1 (2) | PGMEA/PGME (77/20) |
| UDL-10 | A-4 (3) | XL-2 (2) D-1 (0.2) | PGMEA/PGME (77/20) |
| Comparative UDL-1 | R-1 (3) | - | PGMEA/PGME (77/20) |
| Comparative UDL-2 | R-2 (3) | - | PGMEA/PGME (77/20) |

### [Etching Resistance Evaluation]

Each of the compositions for forming a metal-containing film (UDL-1 to -10 and Comparative Examples UDL-1 to -2) was applied onto a silicon substrate and heated by using a hot plate at 250°C for 60 seconds to form a metal-containing film having a film thickness of 30 nm (film thickness "a").

In Comparative Example 1-3, the following silicon atom-containing resist middle layer film material (SOG-1) was applied and baked at 220°C for 60 seconds to form a resist middle layer film having a thickness of 30 nm (film thickness "a").

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportions shown in Table 3; and filtering the solution through a filter made of a fluororesin and having a pore size of 0.1 µm.

**[Table 3]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the ArF silicon-containing middle layer film polymer (SiP1) and thermal crosslinking catalyst (CAT1) used are shown below.

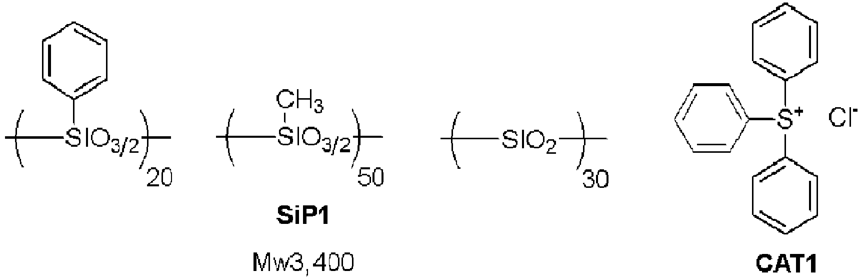

In Comparative Example 1-4, the following organic resist underlayer film material (SOC-1) was applied and baked at 350°C for 60 seconds to form a resist underlayer film with a thickness of 50 nm (film thickness "a").

The organic resist underlayer film composition (SOC-1) was prepared by dissolving the polymer denoted by the organic underlayer film polymer (CP1) in an organic solvent containing 0.1% by mass of FC-4430 (manufactured by Sumitomo 3M Limited) in the proportions shown in Table 4 and filtering the resulting solution through a filter made of a fluororesin having a pore size of 0.1 µm.

**[Table 4]**

| | Polymer | Solvent 1 |
|---|---|---|
| | (parts by mass) | (parts by mass) |
| SOC-1 | CP1 | Propylene glycol monoethyl ether |
| | (100) | (3000) |

The structural formula of the organic underlayer polymer (CP1) used is shown below.

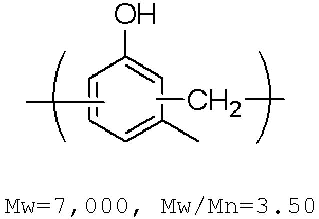

Subsequently, etching was performed with CF₄ gas and O₂ gas under the following conditions by using an etching apparatus CE-300I manufactured by ULVAC, Inc., and the film thickness "b" was measured. Then, the film thickness etched in 1 minute was calculated as an etching rate (nm/min) from the film thickness etched (film thickness "a" - film thickness "b") in a specified time using each gas.

The etching rate for the CF₄ gas was judged as "A (very good)" if it was 20 nm/min or less, "B (good)" if it was 20 nm/min to 30 nm/min, and "C (poor)" if it was 30 nm/min or more.

The etching rate for the O₂ gas was judged as "A (very good)" if it was 20nm/min or less, "B (good)" if it was 20 nm/min to 30 nm/min, and "C (poor)" when it was 30 nm/min or more.

Table 5 shows the results.
Conditions for dry etching with CF₄ gas
Pressure: 3 Pa
Antenna RF power: 100 W
Bias RF power: 15 W
CF₄ gas flow rate: 15 sccm
Time: 30 sec

Conditions for dry etching with O₂ gas
Pressure: 3 Pa
Antenna RF power: 300 W
Bias RF power: 10 W
O₂ gas flow rate: 25 sccm
Time: 30 sec

**[Table 5]**

| Example | Composition for forming metal-containing film | Bake temperature | Etching speed (nm/min) | Etching speed (nm/min) |
|---|---|---|---|---|
| | | °C | CF₄ | O₂ |
| Example 1-1 | UDL-1 | 250°C | A | A |
| Example 1-2 | UDL-2 | 250°C | A | A |
| Example 1-3 | UDL-3 | 250°C | A | A |
| Example 1-4 | UDL-4 | 250°C | A | A |
| Example 1-5 | UDL-5 | 250°C | A | A |
| Example 1-6 | UDL-6 | 250°C | A | A |
| Example 1-7 | UDL-7 | 250°C | A | A |
| Example 1-8 | UDL-8 | 250°C | A | A |
| Example 1-9 | UDL-9 | 250°C | A | A |
| Example 1-10 | UDL-10 | 250°C | A | A |
| Comparative Example 1-1 | Comparative UDL-1 | 250°C | A | A |
| Comparative Example 1-2 | Comparative UDL-2 | 250°C | A | A |
| Comparative Example 1-3 | SOG-1 | 220°C | C | A |
| Comparative Example 1-4 | SOC-1 | 250°C | B | C |

As shown in Table 5, it was shown that the inventive compositions (UDL-1 to -10) for forming a metal-containing film exhibit excellent dry etching resistance to CF₄ gas and O₂ gas.

Due to the excellent resistance to etching using O₂ gas compared to the SOG-1 used in Comparative Example 1-3, they are suitable for a three-layer resist process in which a resist pattern is transferred to a substrate to be processed in combination with an organic resist underlayer film.

Due to the excellent etching resistance to CF₄ gas compared to the SOC-1 used in Comparative Example 1-4, they are suitable for a two-layer resist process in which a resist pattern is transferred to a substrate to be processed in combination with a photoresist top layer.

### [Coating Film Wet Etching Test]

Each of the compositions (UDL-1 to -10, comparative UDL-1 and 2), and SOG-1 were respectively applied onto a silicon substrate and heated by using a hot plate at 250°C for 60 seconds to form a metal-containing film having a film thickness of 30 nm. These metal-containing films were immersed in a basic liquid (a mixed solution of 25% ammonia aqueous solution / 30% hydrogen peroxide aqueous solution / water = 1/1/5) at 65°C for 2 minutes, and the remaining film thickness was measured using an M-2000 high-speed spectroscopic ellipsometer manufactured by J.A. Woollam Co., Inc. to evaluate whether there was a change in the film thickness before and after the basic liquid immersion. A film thickness change of 70% or more was judged as "good," and a film thickness change of less than 70% was judged as "poor."

Table 6 shows the results.

**[Table 6]**

| Example | Composition for forming metal-containing film | Bake temperature | Wet peelability |
|---|---|---|---|
| | | °C | SC1 |
| Example 2-1 | UDL-1 | 250°C | Good |
| Example 2-2 | UDL-2 | 250°C | Good |
| Example 2-3 | UDL-3 | 250°C | Good |
| Example 2-4 | UDL-4 | 250°C | Good |
| Example 2-5 | UDL-5 | 250°C | Good |
| Example 2-6 | UDL-6 | 250°C | Good |
| Example 2-7 | UDL-7 | 250°C | Good |
| Example 2-8 | UDL-8 | 250°C | Good |
| Example 2-9 | UDL-9 | 250°C | Good |
| Example 2-10 | UDL-10 | 250°C | Good |
| Comparative Example 2-1 | Comparative UDL-1 | 250°C | Poor |
| Comparative Example 2-2 | Comparative UDL-2 | 250°C | Good |
| Comparative Example 2-3 | SOG-1 | 220°C | Poor |

As shown in Table 6, the inventive compositions (UDL-1 to -10) were good in terms of peelability using basic liquid compared to a metal-containing film formed from Comparative Example UDL-1, which is not containing a ligand derived from an organic sulfonic acid compound, and compared to a silicon-containing film formed from SOG-1. It is conjectured that the penetration of the stripping solution is improved because it contains ligands derived from an organic sulfonic acid compound.

### [Patterning Test]

An SOC film (ODL-306, carbon contained amount: 61 atomic%) manufactured by Shin-Etsu Chemical Co., Ltd. was applied as an organic resist underlayer film by spin-coating onto a silicon wafer substrate on which an SiO₂ film having a thickness of 100 nm had been formed, and the substrate was then baked at 350°C for 60 seconds to form a carbon film having a thickness of 50 nm. Then, the composition for forming a metal-containing film (UDL-1 to 10 and Comparative Examples UDL-1 and 2) and SOG-1 were applied onto the organic resist underlayer film and the substrate was then baked at 250°C or 220°C for 60 seconds to form a resist middle layer film having a thickness of 30 nm.

Subsequently, the resist material shown in Table 7 was spin-coated onto the metal-containing film, and prebaked at 105°C for 60 seconds using a hot plate to prepare a resist film with a thickness of 40 nm. This was exposed using an EUV scanner NXE3300 manufactured by ASML Holding N.V. (NA 0.33, sigma 0.9/0.6, dipole illumination, L/S pattern with a pitch of 36 nm on the wafer), PEB was performed on a hot plate at 100°C for 60 seconds, development was performed in a 2.38 mass% TMAH aqueous solution for 30 seconds, and a pattern with a line dimension of 22 nm was obtained.

The line size was measured using a CD-SEM (CG5000) manufactured by Hitachi High-Tech Corporation, and pattern collapse was observed. When no pattern collapse was observed, the result was rated as good, and when pattern collapse was observed, the result was judged as poor. Furthermore, the cross-sectional shape was observed using a scanning electron microscope (S-4800) manufactured by Hitachi High-Tech Corporation. When no footing shape was observed, the sample was judged as "good", and when a clear footing shape was observed, the sample was rated as "poor".

In addition, the exposure amount required to obtain a line size of 18 nm was evaluated as the sensitivity, and it was determined that the lower the exposure amount, the more it contributes to higher sensitivity of the resist top layer film. Table 8 shows the results.

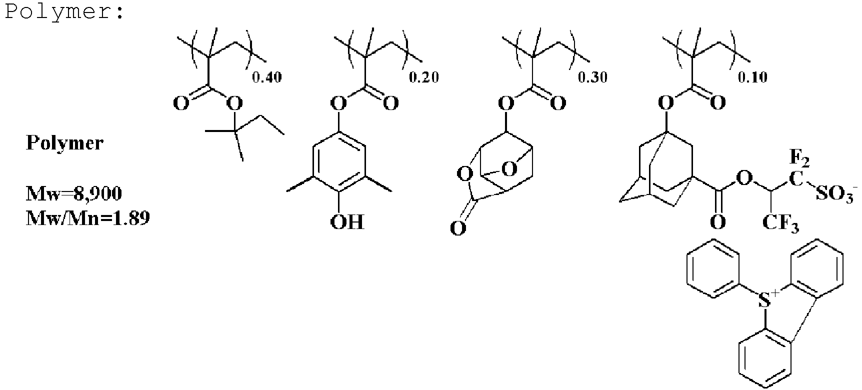

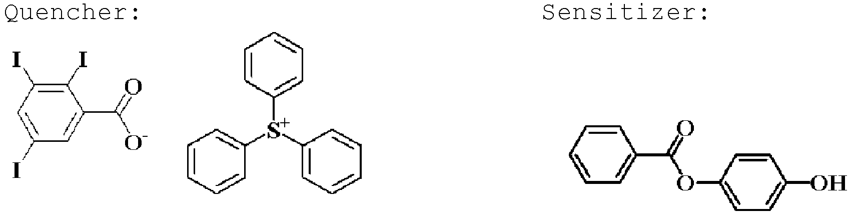

### Surfactant: FC-4430 manufactured by 3M

**[Table 7]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

| | | | | | |
|---|---|---|---|---|---|
| Organic solvent: PGMEA (Propylene glycol monoethyl ether) CyHO (Cyclohexanone) PGME (Propylene glycol monomethyl ether) | | | | | |

**[Table 8]**

| Example | Composition for forming metal-containing film | Baking temperature | L/S patterning test | |
|---|---|---|---|---|
| | | °C | Sensitivity | Cross-section after development |
| Example 3-1 | UDL-1 | 250°C | 45.5 | Rectangle |
| Example 3-2 | UDL-2 | 250°C | 46.6 | Rectangle |
| Example 3-3 | UDL-3 | 250°C | 45.3 | Rectangle |
| Example 3-4 | UDL-4 | 250°C | 46.4 | Rectangle |
| Example 3-5 | UDL-5 | 250°C | 46.8 | Rectangle |
| Example 3-6 | UDL-6 | 250°C | 46.3 | Rectangle |
| Example 3-7 | UDL-7 | 250°C | 46.2 | Rectangle |
| Example 3-8 | UDL-8 | 250°C | 46.4 | Rectangle |
| Example 3-9 | UDL-9 | 250°C | 46.2 | Rectangle |
| Example 3-10 | UDL-10 | 250°C | 46.3 | Rectangle |
| Comparative Example 3-1 | Comparative Example UDL-1 | 250°C | - | Pattern collapse |
| Comparative Example 3-2 | Comparative Example UDL-2 | 250°C | - | Pattern collapse |
| Comparative Example 3-3 | SOG-1 | 220°C | 47.8 | Footing shape |

As shown in Table 8, in the composition for forming a metal-containing film of the present invention (UDL-1 to 10), a vertical-profile-shaped pattern area can be obtained in patterning formation of line width 22 nm using EUV exposure, and no pattern collapse was recognized. It is presumed that the compound for forming a metal-containing film of the present invention has improved adhesiveness to the resist pattern due to containing at least one of the following: an unsaturated hydrocarbon group excluding an aromatic ring; and an alkoxy group. In addition, it is presumed that the inclusion of a sulfone structure has improved the permeability of the developer, resulting in a resist pattern with high rectangularity after development. Furthermore, it was found that when the metal-containing film of the present invention is used as a resist underlayer film, a resist pattern can be formed with high sensitivity.

On the other hand, it was found that Comparison Example UDL-1, which used a compound not containing a sulfonyl group as a ligand, and Comparison Example UDL-2, which used an organic sulfonic acid compound with a structure different from the formula (s) as a ligand, had a smaller effect of suppressing the collapse of the fine-line pattern than the compositions for forming a metal-containing film of the present invention (UDL-1 to 10). In Comparative Example 3-3 using SOG-1, no pattern collapse was observed, but the cross-sectional shape of the resist showed a footing shape.

As described above, the present invention has excellent adhesion to the upper layer resist, and therefore is highly effective for suppressing the collapse of fine line patterns. Furthermore, it is possible to form a metal-containing film that can contribute to improving the sensitivity of the upper layer resist, and the metal-containing film can be easily removed. Therefore, the present invention is highly useful in the field of EUV lithography.

The present description includes the following embodiments.
[1]: A compound (A) for forming a metal-containing film, wherein
   the compound (A) for forming a metal-containing film is a compound comprising at least one kind of metal atom selected from the group consisting of Ti, Zr, and Hf and a ligand coordinated to the metal atom, and
   at least one of the ligands is derived from the organic sulfonic acid compound represented by the following formula (s): 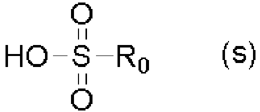 wherein R₀ represents a monovalent organic group having 1 to 30 carbon atoms, and containing at least one of the following: an unsaturated hydrocarbon group excluding an aromatic ring; and an alkoxy group.
[2]: The compound for forming a metal-containing film according to [1], wherein R₀ is a monovalent organic group having 1 to 30 carbon atoms, and containing at least one of the following: a vinyl group; an allyl group; an allyloxy group; an ethynyl group; a propargyl group; a propargyloxy group; and an alkoxy group.
[3]: The compound for forming a metal-containing film according to [2], wherein R₀ is an alkyl group having 2 to 30 carbon atoms or an aryl group having 7 to 30 carbon atoms, and containing at least one functional group selected from the following: a vinyl group; an allyl group; an allyloxy group; an ethynyl group; a propargyl group; a propargyloxy group; and an alkoxy group.
[4]: The compound for forming a metal-containing film according to [3], wherein R₀ is an aryl group having 7 to 30 carbon atoms, and containing at least one functional group selected from the following: a vinyl group; an allyl group; an allyloxy group; an ethynyl group; a propargyl group; a propargyloxy group; and an alkoxy group.
[5]: The compound for forming a metal-containing film according to any one of [1] to [4], wherein the compound (A) for forming a metal-containing film further contains a ligand derived from a silicon compound represented by the following general formula (w): 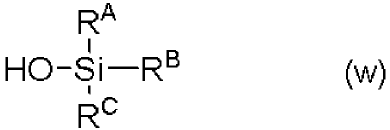 wherein R^{A}, R^{B}, and R^{C} each represent any organic group selected from the following: an organic group having 2 to 30 carbon atoms and a crosslinking group of any structure represented by one of the following general formulae (w-1) to (w-3); a substituted or unsubstituted alkyl group having 1 to 20 carbon atoms; and an aryl group having 6 to 20 carbon atoms: 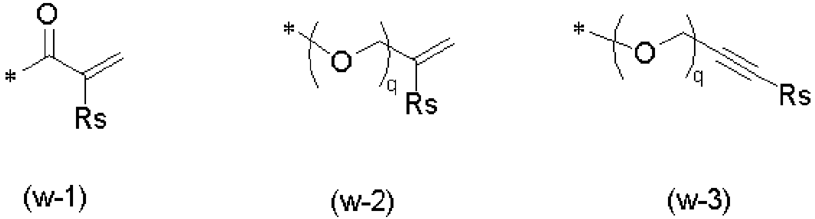 wherein Rₛ represents a hydrogen atom or a monovalent organic group having 1 to 10 carbon atoms, "q" represents 0 or 1, and "*" represents an attachment point.
[6]: The compound for forming a metal-containing film according to any one of [1] to [5], wherein the compound (A) for forming a metal-containing film is a reaction product of the following: a metal compound represented by the following formula (a) or a metal compound containing either a hydrolysate, a condensate, or a hydrolysis condensate of a metal compound represented by the following formula (a); and a compound containing a structure represented by the formula (s):

   **LₐMX_{b}** **(a)**

   wherein M is any one of Ti, Zr, and Hf; L is a monodentate ligand or a multidentate ligand having 1 to 30 carbon atoms; X is a hydrolyzable group selected from the following: a halogen atom; an alkoxy group; a carboxylate group; an acyloxy group; and -NR¹R², wherein R¹ and R² are each independently a hydrogen atom or a monovalent organic group having 1 to 20 carbon atoms; and "a" and "b" each represent an integer from 0 to 4 such that a + b = 2 to 4.
[7]: The compound for forming a metal-containing film according to [6], wherein the formula (a) has the structure of the following formula (a-1):

   M(OR^{1A})₄ (a-1)

   wherein M is any one of Ti, Zr, and Hf, and R^{1A} is a monovalent organic group having 1 to 20 carbon atoms.
[8]: A composition for forming a metal-containing film, wherein the composition for forming a metal-containing film serves as a metal-containing film used in semiconductor manufacturing, and contains the compound (A) for forming a metal-containing film according to any one of [1] to [7], and an organic solvent (B).
[9]: The composition for forming a metal-containing film according to [8], wherein the composition further contains at least one kind from among the following: a crosslinking agent (C); an acid generator (D); and a surfactant (E).
[10]: The composition for forming a metal-containing film according to [8] or [9], wherein the organic solvent (B) contains, as a high-boiling-point solvent (B1), at least one kind of organic solvent having a boiling point of 180°C or higher.
[11]: A patterning process for forming a pattern in a substrate to be processed, comprising the steps of:
   (I-1) applying the composition for forming a metal-containing film according to any one of [8] to [10] directly or indirectly onto a substrate to be processed, followed by heating to form a metal-containing film;
   (I-2) forming a resist upper layer film directly or indirectly on the metal-containing film by using a photoresist material;
   (I-3) subjecting the resist upper layer film to pattern exposure and then development with a developer to form a pattern in the resist upper layer film;
   (I-4) transferring the pattern directly or indirectly to the metal-containing film by dry etching using the resist upper layer film having the formed pattern as a mask; and
   (I-5) processing the substrate to be processed directly or indirectly while using the metal-containing film having the formed pattern as a mask to form the pattern in the substrate to be processed.
[12]: A patterning process according to [11], wherein at least one organic resist underlayer film is contained between the substrate to be processed and the metal-containing film.
[13]: The patterning process according to [11] or [12], wherein the resist upper layer film is formed directly on the metal-containing film.
[14]: The patterning process according to any one of [11] to [13], wherein a step of forming a pattern by processing a film directly below the metal-containing film using the metal-containing film as a mask is performed, followed by a step of removing the metal-containing film with a chemical solution.
[15]: The patterning process according to [14], wherein the chemical solution is a solution containing hydrogen peroxide and an acid, or a solution containing a base, hydrogen peroxide, and water.

It should be noted that the present invention is not limited to the above-described embodiments. The embodiments are just examples, and any examples that substantially have the same features and demonstrate the same functions and effects as those in the technical concepts disclosed in the claims of the present invention are included in the technical scope of the present invention.

## Claims

1. A compound (A) for forming a metal-containing film, wherein
the compound (A) for forming a metal-containing film is a compound comprising at least one kind of metal atom selected from the group consisting of Ti, Zr, and Hf and a ligand coordinated to the metal atom, and
at least one of the ligands is derived from the organic sulfonic acid compound represented by the following formula (s): 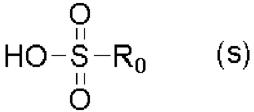 wherein R₀ represents a monovalent organic group having 1 to 30 carbon atoms, and containing at least one of the following: an unsaturated hydrocarbon group excluding an aromatic ring; and an alkoxy group.

2. The compound for forming a metal-containing film according to claim 1, wherein R₀ is a monovalent organic group having 1 to 30 carbon atoms, and containing at least one of the following: a vinyl group; an allyl group; an allyloxy group; an ethynyl group; a propargyl group; a propargyloxy group; and an alkoxy group.

3. The compound for forming a metal-containing film according to claim 2, wherein R₀ is an alkyl group having 2 to 30 carbon atoms or an aryl group having 7 to 30 carbon atoms, and containing at least one functional group selected from the following: a vinyl group; an allyl group; an allyloxy group; an ethynyl group; a propargyl group; a propargyloxy group; and an alkoxy group.

4. The compound for forming a metal-containing film according to claim 3, wherein R₀ is an aryl group having 7 to 30 carbon atoms, and containing at least one functional group selected from the following: a vinyl group; an allyl group; an allyloxy group; an ethynyl group; a propargyl group; a propargyloxy group; and an alkoxy group.

5. The compound for forming a metal-containing film according to any one of claims 1 to 4, wherein the compound (A) for forming a metal-containing film further contains a ligand derived from a silicon compound represented by the following general formula (w): 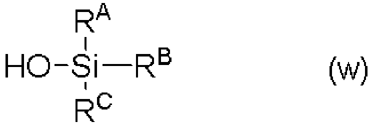 wherein R^{A}, R^{B}, and R^{C} each represent any organic group selected from the following: an organic group having 2 to 30 carbon atoms and a crosslinking group of any structure represented by one of the following general formulae (w-1) to (w-3); a substituted or unsubstituted alkyl group having 1 to 20 carbon atoms; and an aryl group having 6 to 20 carbon atoms: 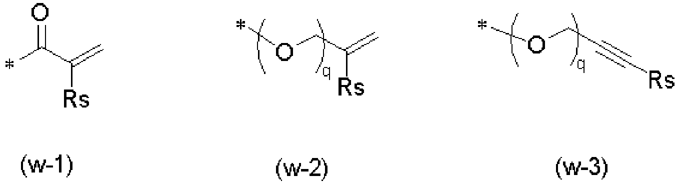 wherein Rₛ represents a hydrogen atom or a monovalent organic group having 1 to 10 carbon atoms, "q" represents 0 or 1, and "*" represents an attachment point.

6. The compound for forming a metal-containing film according to any one of claims 1 to 5, wherein the compound (A) for forming a metal-containing film is a reaction product of the following: a metal compound represented by the following formula (a) or a metal compound containing either a hydrolysate, a condensate, or a hydrolysis condensate of a metal compound represented by the following formula (a); and a compound containing a structure represented by the formula (s):
**LₐMX_{b}** **(a)**
wherein M is any one of Ti, Zr, and Hf; L is a monodentate ligand or a multidentate ligand having 1 to 30 carbon atoms; X is a hydrolyzable group selected from the following: a halogen atom; an alkoxy group; a carboxylate group; an acyloxy group; and -NR¹R², wherein R¹ and R² are each independently a hydrogen atom or a monovalent organic group having 1 to 20 carbon atoms; and "a" and "b" each represent an integer from 0 to 4 such that a + b = 2 to 4.

7. The compound for forming a metal-containing film according to claim 6, wherein the formula (a) has the structure of the following formula (a-1):
M (OR^{1A})₄ (a - 1)
wherein M is any one of Ti, Zr, and Hf, and R^{1A} is a monovalent organic group having 1 to 20 carbon atoms.

8. A composition for forming a metal-containing film, wherein the composition for forming a metal-containing film serves as a metal-containing film used in semiconductor manufacturing, and contains the compound (A) for forming a metal-containing film according to any one of claims 1 to 7, and an organic solvent (B).

9. The composition for forming a metal-containing film according to claim 8, wherein the composition further contains at least one kind from among the following: a crosslinking agent (C); an acid generator (D); and a surfactant (E).

10. The composition for forming a metal-containing film according to claim 8 or 9, wherein the organic solvent (B) contains, as a high-boiling-point solvent (B1), at least one kind of organic solvent having a boiling point of 180°C or higher.

11. A patterning process for forming a pattern in a substrate to be processed, comprising the steps of:
(I-1) applying the composition for forming a metal-containing film according to any one of claims 8 to 10 directly or indirectly onto a substrate to be processed, followed by heating to form a metal-containing film;
(I-2) forming a resist upper layer film directly or indirectly on the metal-containing film by using a photoresist material;
(I-3) subjecting the resist upper layer film to pattern exposure and then development with a developer to form a pattern in the resist upper layer film;
(I-4) transferring the pattern directly or indirectly to the metal-containing film by dry etching using the resist upper layer film having the formed pattern as a mask; and
(I-5) processing the substrate to be processed directly or indirectly while using the metal-containing film having the formed pattern as a mask to form the pattern in the substrate to be processed.

12. A patterning process according to claim 11, wherein at least one organic resist underlayer film is contained between the substrate to be processed and the metal-containing film.

13. The patterning process according to claim 11 or 12, wherein the resist upper layer film is formed directly on the metal-containing film.

14. The patterning process according to any one of claims 11 to 13, wherein a step of forming a pattern by processing a film directly below the metal-containing film using the metal-containing film as a mask is performed, followed by a step of removing the metal-containing film with a chemical solution.

15. The patterning process according to claim 14, wherein the chemical solution is a solution containing hydrogen peroxide and an acid, or a solution containing a base, hydrogen peroxide, and water.
